Europäisches Patentamt

European Patent Office

Office européen des brevets

(19)

(11) Veröffentlichungsnummer: **0 166 032**
**B1**

(12) # EUROPÄISCHE PATENTSCHRIFT

(45) Veröffentlichungstag der Patentschrift:
25.01.89

(21) Anmeldenummer: 84115820.7

(22) Anmeldetag: 19.12.84

(51) Int. Cl.⁴: **C 30 B 31/14,** C 30 B 25/12,
C 30 B 33/00

(54) Trägerhorde aus Quarzglas für scheibenförmige Substrate.

(30) Priorität: 28.05.84 DE 3419866

(43) Veröffentlichungstag der Anmeldung:
02.01.86 Patentblatt 86/1

(45) Bekanntmachung des Hinweises auf die Patenterteilung:
25.01.89 Patentblatt 89/4

(84) Benannte Vertragsstaaten:
CH DE FR GB LI

(56) Entgegenhaltungen:
GB-A-1 571 306

(73) Patentinhaber: HERAEUS QUARZSCHMELZE
GMBH, Quarzstrasse, D-6450 Hanau (DE)

(72) Erfinder: Schülke, Karl- Albert, Bergstrasse 6,
D-6451 Neuberg 2 (DE)

(74) Vertreter: Heinen, Gerhard, Dr., W.C. Heraeus
GmbH Zentralbereich Patente und Lizenzen
Heraeusstrasse 12- 14, D-6450 Hanau (DE)

## Beschreibung

Die vorliegende Erfindung betrifft eine Trägerhorde aus Quarzglas oder keramischem Werkstoff mit einem profilierten Aufnahmekörper für scheibenförmige Substrate, insbesondere für runde Substratscheiben, wobei die Substrate mittels Schlitzen in dem Aufnahmekörper gehaltert sind.

Eine derartige Horde ist aus der DE-PS-3 024 751 bekannt. Es handelt sich hierbei um einen wannenartig profilierten Aufnahmekörper aus Quarzglas mit Schlitzen im Bodenbereich und den nach oben weisenden Endbereichen der Wanne. Diese Schlitze bilden eine 3-Punkt-Stützung der darin eingesetzten Substratscheiben. Bei einer ungebrauchten, fabrikneuen Horde sitzen die einzelnen Substratscheiben mit ihrem gesamten Gewicht zunächst auf dem Bodenbereich der Horde auf. Die Schlitze in den Endbereichen der Wanne dienen lediglich zur Führung der Substrate. Unter dem Einfluß des Gewichtes der in die Horde eingesetzten Substratscheiben und unter dem Einfluß der sehr hohen Temperaturen, bei denen die Substrate behandelt werden und denen demzufolge auch die Horde unterliegt, tritt bei längerer Benutzung eine leichte Deformierung der Horde auf, so daß die Substrate auch in den Schlitzen an den Endbereichen der Wanne zum Anliegen kommen und eine 3-Punkt-Abstützung entsteht. Ein solcher Hordentyp muß praktisch stets von außen durch spezielle Tragerahmen abgestützt werden. Solche Horden zeigen ihre Grenzen einmal in der herstellbaren Materialdicke - zur Erzielung einer ausreichenden Festigkeit -, weiterhin in der Genauigkeit der Konturen und Profilierung.

Weiterhin ist aus dem DE-GM-8 021 868 eine Horde aus Stäben, eine sogenannte Stabhorde, mit vier geschlitzten Quarzglasstäben bekannt, die mit einem zwischen dem oberen und unteren Stäben angeordneten Quarzglasstab unverrückbar miteinander verschmolzen sind. Diese Stabhorde weist unter den Horden noch die günstigsten Eigenschaften auf, weil sie nur aus wenigen und dazu noch gleichen Teilen besteht. Unvermeidbar ist jedoch bei längerem Gebrauch ein sich Absenken der frei hängenden Längsstäbe.

Der vorliegenden Erfindung liegt nun die Aufgabe zugrunde, eine Trägerhorde aus Quarzglas oder keramischem Werkstoff für scheibenförmige Substrate, insbesondere für runde Substratscheiben, zu schaffen, die eine gut zugängliche Gestalt aufweist bei gleichzeitiger hoher Stabilität und die in ihrem Aufbau im Hinblick auf die unterschiedlichen Substratscheiben äußerst variabel ist.

Diese Aufgabe wird erfindungsgemäß durch die kennzeichnenden Merkmale des Anspruchs 1 gelöst. Die gesamte Nutzlast in Form der Substratscheiben stützt sich bei der erfindungsgemäßen Profilhorde in zwei punkt- bis linienförmigen Bereichen der V-förmig zueinander ausgerichteten U-förmigen Profilstäbe ab. Hierbei bleiben die Bereiche der Schlitzungen in den Seitenteilen frei von Belastungen und Deformationen, einmal abgesehen von der sehr geringen Eigengewichtsbelastung. Die gesamte Last der Substrate kann direkt in ihrer Wirkungslinie, d. h. auf der Unterseite der Bodenteile gegebenenfalls durch entsprechende Tragerahmen abgefangen werden, was besonders vorteilhaft ist. Die Horde setzt sich aus nur wenigen Einzelteilen zusammen, nämlich aus den beiden U-förmigen Profilstäben und den beiden Querstäben. Je nach Größe der Substratscheiben können die auf Vorrat gefertigten U-förmigen Profilstäbe in ihrer Neigung bzw. Stellung zur Substratmitte entsprechend positioniert mit den Querstäben verschweißt werden. Da die zu behandelnden Substratscheiben normalerweise nur in einer begrenzten Anzahl von Größen zum Einsatz kommen, z. B. runde Substratscheiben mit einem Durchmesser von 100 mm, 125 mm, 150 mm und 200 mm, reicht es auf alle Fälle aus, zwei unterschiedliche U-förmige Profilstäbe zu bevorraten. Durch die mit den U-Profilstäben erzielbare offene Gestalt ist die Horde beim Be- und Entladen gut zugänglich.

Je nach Form der Substratscheiben kann es vorteilhaft sein, die Kontur der Auflageflächen der Bodenteile der Außenkontur der Substratscheiben anzupassen, um eine linienförmige Auflage zu erreichen, oder aber die den Substratscheiben zugekehrten Flächen der Bodenteile eben auszubilden, um eine punktförmige Auflage bei runden Substratscheiben bzw. eine linienförmige Auflage bei Substratscheiben mit geraden Seitenabschnitten zu erzielen.

Da die Substrate lediglich auf den Bodenteilen punkt- oder linienförmig aufliegen und die Schlitzungen in den Seitenteilen lediglich zur Führung der Substratscheiben dienen, können diese auch vorteilhaft bis auf das Niveau der Bodenteile geschlitzt werden, wodurch erreicht wird, daß die Horde für ein größeres Sortiment von Substratscheiben unterschiedlicher Durchmessers geeignet ist, ohne daß die verschiedenen Substratscheiben, d. h. die Scheiben größten bzw. kleinsten Durchmessers, in den Schlitzen der Seitenteile zu einem unerwünschten Aufliegen kommen.

Die Stabilität der Horde kann zusätzlich durch Stützkörper auf der Unterseite der Bodenteile, und zwar im Bereich der punkt- oder linienförmigen Auflage der Substratscheiben auf den Bodenteilen, erzielt werden. Hierbei wird die gesamte Masse der Substratscheiben bzw. werden die gesamten Kräfte direkt in die Stützkörper geleitet. Besonders vorteilhaft sind hierbei fest mit den Bodenteilen verschweißte Stützkörper, die darüber hinaus einen runden Querschnitt aufweisen. Bei diesen Maßnahmen kann das Auftreten von Spannungen dadurch vermieden werden, daß die Profilkörper und die Stützkörper aus dem gleichen Werkstoff, beipielweise aus Quarzglas, gefertigt sind.

Als günstig hat sich eine lichte Weite zwischen den Seitenteilen der U-förmigen Profilkörper erwiesen, die 10 bis 70 % der Längenausdehnung bzw. des Durchmessers der Substratscheiben entspricht, wobei hier ein Optimum bei etwa 30 % der Längenausdehnung bzw. des Durchmessers der Substrate liegt.

Bei der Anordnung der Bodenteile sollte in vorteilhafterweise beachtet werden, daß die Verbindungslinien von der Substratmitte zu den Berührungspunkten der Substrate mit den Bodenteilen der Profile - unter einem rechten Winkel - einen Winkel zwischen 15° und 150° einschließen; geeigneter ist jedoch ein Winkel zwischen 60° und 120° und es sollte bevorzugt der eingeschlossene Winkel bei etwa 90° liegen.

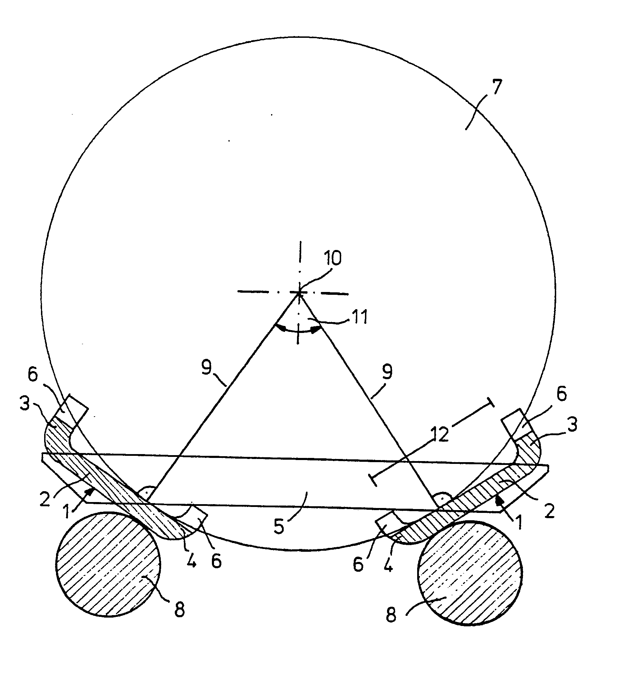

Weitere Einzelheiten und Merkmale der Erfindung ergeben sich aus der nachfolgenden Beschreibung eines Ausführungsbeispiels anhand der Zeichnung.

Die Zeichnung zeigt einen Schnitt durch eine Trägerhorde gemäß der Erfindung mit darin eingesetzter runder Substratscheibe.

Die Trägerhorde weist zwei U-förmige Profilstäbe 1 mit jeweils einem Bodenteil 2 und einem äußeren Seitenteil 3 sowie einem inneren Seitenteil 4 auf. Die beiden U-Profilstäbe 1 sind an ihren Enden über jeweils einen Querstab 5 im Abstand zueinander ausgerichtet, und zwar so, daß die Bodenteile 2 der Profilstäbe 1 V-förmig zueinander ausgerichtet sind. In diesem Ausführungsbeispiel sind die Seitenteile 3, 4 mit Schlitzen 6 versehen, die bei den unteren Seitenteilen 4 in einer Tiefe ausgeführt sind, die bis auf das Niveau der Bodenteile 2 reicht, während die oberen Seitenteile 3 nur bis etwa zu ihrer Mitte hin geschlitzt sind. Die Seitenteile 3, 4 der Profilstäbe 1 können sich, genau rechtwinklig zu den Bodenteilen 2 erstrecken, oder aber geringfügig aus dieser Lage nach außen geneigt sein. Die in die Trägerhorde eingesetzte runde Substratscheibe 7 stützt sich nur punktförmig auf den Bodenteilen 2 der Profilstäbe 1 ab. Die Schlitze 6 dienen nur zur seitlichen Stützung und Parallelführung der einzelnen Substratscheiben 7. Die U-Profilstäbe sind so zueinander V-förmig ausgerichtet, daß die Verbindungslinie 9 von der Substratmitte 10 zu den Berührungspunkten der Substrate 7 mit den Bodenteilen 2 einen Winkel 11 von etwa 70° einschließen, wobei die Bodenteile 2 der Profilkörper 1 senkrecht zu den Verbindungslinien 9 ausgerichtet sind. Die lichte Weite 12 zwischen den beiden Seitenteilen 3, 4 der Profilstäbe beträgt im vorliegenden Fall 35 mm die Stärke der Profilstäbe etwa 4 mm. Eine so dimensionierte Profilhorde ist gut geeignet für runde Substratscheiben mit einem Durchmesser zwischen 120 und 150 mm. Bei den Querstäben 5 handelt es sich um Quarzglasrohre, die an ihren Enden abgeschrägt sind. Die Stabilität der Horde kann zusätzlich durch Stützkörper 8 auf der Unterseite der Bodenteile 2 erzielt werden.

## Patentansprüche

1. Trägerhorde aus Quarzglas oder keramischem Werkstoff mit einem profilierten Aufnahmekörper für scheibenförmige Substrate, insbesondere für runde Substratscheiben, wobei die Substrate mittels Schlitzen in dem Aufnahmekörper gehaltert sind, dadurch gekennzeichnet, daß der Aufnahmekörper als zwei im Querschnitt U-förmige Profilstäbe (1) jeweils mit einem Bodenteil (2) und zwei Seitenteilen (3, 4) ausgebildet ist, die so mittels Querstäben (5) im Abstand zueinander angeordnet sind, daß die Bodenteile (2) der Profilstäbe V-förmig zueinander ausgerichtet sind, wobei die Schlitze (6) in den Seitenteilen (3, 4) in einer Tiefe ausgeführt sind, daß die aufrechtstehenden Substrate (7) auf den Bodenteilen (2) punkt- oder linienförmig aufliegen.

2. Trägerhorde nach Anspruch 1, dadurch gekennzeichnet, daß wenigstens die der Substratscheibe (7) zugekehrte Fläche der Bodenteile (2) der Außenkontur der Substratscheibe (7) im Bereich ihrer Auflage angenähert ist.

3. Trägerhorde nach Anspruch 1, dadurch gekennzeichnet, daß wenigstens die der Substratscheibe (7) zugekehrte Fläche der Bodenteile (2) eben ist.

4. Trägerhorde nach einem der Ansprüche 1 bis 3, dadurch gekennzeichnet, daß die Seitenteile (3, 4) bis auf das Niveau der Bodenteile (2) geschlitzt sind.

5. Trägerhorde nach einem der Ansprüche 1 bis 4, dadurch gekennzeichnet, daß im Bereich der Berührungspunkte bzw. Auflagefläche der Substrate (7) auf den Bodenteilen (2) auf deren Unterseite Stützkörper in Form von Füßen oder Stäben (8) angeordnet sind.

6. Trägerhorde nach Anspruch 5, dadurch gekennzeichnet, daß die Stützkörper fest mit den Bodenteilen (2) verschweißt sind.

7. Trägerhorde nach Anspruch 5 oder 6, dadurch gekennzeichnet, daß die Stützkörper im Querschnitt runde Stäbe (8) sind.

8. Trägerhorde nach einem der Ansprüche 5 bis 7, dadurch gekennzeichnet, daß die Profilkörper (1) und die Stützkörper (8) aus dem gleichen Merkstoff bestehen.

9. Trägerhorde nach einem der Ansprüche 1 bis 8, dadurch gekennzeichnet, daß die lichte Weite (12) zwischen den Seitenteilen (3, 4) 10 bis 70 % der Längsausdehnung bzw. des Durchmessers der Substrate (7) beträgt.

10. Trägerhorde nach Anspruch 9, dadurch gekennzeichnet, daß die lichte Weite zwischen den Seitenteilen (3, 4) etwa 30 % der Längenausdehnung bzw. des Durchmessers der Substrate (7) entspricht.

11. Trägerhorde nach einem der Ansprüche 1 bis 10, dadurch gekennzeichnet, daß die Verbindungslinien (9) von der Substratmitte (10) zu den Berührungspunkten der Substrate (7) mit den Bodenteilen (2) der Profilstäbe (1) einen Winkel (11) zwischen 15° und 150° einschließen.

12. Trägerhorde nach Anspruch 11, dadurch gekennzeichnet, daß der eingeschlossene Winkel (11) zwischen 60° und 120° beträgt.

13. Trägerhorde nach Anspruch 12, dadurch gekennzeichnet, daß der eingeschlossene Winkel (11) etwa 90° beträgt.

**Revendications**

1. Claie de support en verre de silice ou matériau céramique, comprenant un élément porteur et de positionnement profité pour des substrats discoïdes, en particulier pour des substrats sous forme de disques circulaires, qui sont maintenus en place dans l'élément porteur par des encoches, caractérisée en ce que l'élément porteur est réalisé sous forme de deux barres profilées (1) de section droite en U, possédant chacune une partie de fond ou base (2) et deux parties latérales ou ailes (3, 4), qui sont maintenues à distance l'une de l'autre par des barres transversales (5), de manière que les bases (2) des barres profilées soient disposées en V l'une par rapport à l'autre, les encoches (6) dans les ailes (3, 4) ayant une profondeur telle que les substrats (7), placés debout, ont des appuis ponctuels ou linéaires sur les bases (2).

2. Claie selon la revendication 1, caractérisée en ce qu'au moins la face des bases (2) tournée vers les substrats discoïdes (7) est adaptée approximativement au contour extérieur du substrat discoïde (7) dans la région de son appui.

3. Claie selon la revendication 1, caractérisée en ce qu'au moins la face des bases (2) tournée vers les substrats discoïdes (7) est plane.

4. Claie selon l'une des revendications 1 à 3, caractérisée en ce que les ailes (3, 4) sont encochées jusqu'au niveau des bases (2).

5. Claie selon une des revendications 1 à 4, caractérisée en ce que des éléments d'appui sous forme de pieds ou de barres (8) sont disposés sur le dessous des bases (2) dans la région des points ou des surfaces d'appui des substrats (7) sur ces bases.

6. Claie selon la revendication 5, caractérisée en ce que les éléments d'appui sont soudés aux bases (2).

7. Claie selon la revendication 5 ou 6, caractérisée en ce que les éléments d'appui sont des barres (8) de section droite circulaire.

8. Claie selon une des revendications 5 à 7, caractérisée en ce que les éléments profilés (1) et les éléments d'appui (8) sont réalisés du même matériau.

9. Claie selon une des revendications 1 à 8, caractérisée en ce que la largeur intérieure (12) entre les ailes (3, 4) correspond à 10 - 70 % de l'étendue longitudinale ou du diamètre des substrats (7).

10. Claie selon la revendication 9, caractérisée en ce que la largeur intérieure entre les ailes (3, 4) correspond à peu près à 30 % de l'étendue longitudinale ou du diamètre des substrats (7).

11. Claie selon une des revendications 1 à 10, caractérisée en ce que les lignes (9) reliant le centre (10) des substrats aux points de contact des substrats (7) avec les bases (2) des barres profilées (1) renferment entre elles un angle (11) compris entre 15 et 150°.

12. Claie selon la revendication 11, caractérisée en ce que l'angle (11) formé entre lesdites lignes est compris entre 60 et 120°.

13. Claie selon la revendication 12, caractérisée en ce que l'angle (11) formé entre lesdites lignes est d'environ 90°.

**Claims**

1. A carrier rack of quartz glass or ceramics material, comprising a shaped receiving element for disc-like substrates, in particular for round substrate discs, wherein the substrates are secured in the receiving element by means of slots, characterised in that the receiving element is constructed in each case as two cross-sectionally U-shaped bar sections (1) each with a base part (2) and two lateral parts (3, 4), which are so arranged spaced from one another by means of transverse bars (5) that the base portions (2) of the bar sections are lined up in a V-formation with respect to each other, the slots (6) in the lateral parts (3, 4) being made with a depth such that the upright substrates (7) rest on the base portions (2) in punctiform or linear manner.

2. A carrier rack according to claim 1, characterised in that at least the surface of the base portions (2) facing towards the substrate disc (7) is made to approximate to the external outline of the substrate disc (7) in the region of its contact.

3. A carrier rack according to claim 1, characterised in that at least the surface of the base portions (2) facing towards the substrate disc (7) is plane.

4. A carrier rack according to one of claims 1 to 3 characterised in that the lateral parts (3, 4) are slotted as far as the level of the base portions (2).

5. A carrier rack according to one of claims 1 to 4, characterised in that in the region of the points of contact or bearing surfaces of the substrates (7) on the said base portions, on the underside of the latter, there are arranged supporting elements in the form of feet or bars (8).

6. A carrier rack according to claim 5, characterised in that the supporting elements are fixedly interwelded with the base portions (2).

7. A carrier rack according to claim 5 or 6, characterised in that the supporring elements are cross-sectionally round bars (8).

8. A carrier rack according to one of claims 5 to 7, characterised in that the shaped elements (1) and the supporting elements (8) consist of the same material.

9. A carrier rack according to one of the claims 1 to 8, characterised in that the clear distance (12) between the lateral parts (3, 4) amounts to 10 to 70 % of the longitudinal extension or diameter of the substrates (7).

10. A carrier rack according to clam 9, characterised in that the clear distance between the lateral parts (3, 4) corresponds approximately to 30 % of the longitudinal extension or diameter of the substrates (7).

11. A carrier rack according to one of the claims 1 to 10, characterised in that the connecting lines (9) from the substrate centre (10) to the points of contact of the substrates (7) with the base portions (2) of the bar sections (1) subtend an angle (11) of between 15° and 150°.

12. A carrier rack according to claim 11, characterised in that the subtended angle (11) amounts to between 60° and 120°.

13. A carrier rack according to claim 12, characterised in that the subtended angle (11) amounts to approximately 90°.